# FASCICULE DE BREVET EUROPEEN

(11) **EP 0 892 498 B1**
(45) Date de publication et mention de la délivrance du brevet: **13.09.2006**
(21) Numéro de dépôt: 98401821.8
(22) Date de dépôt: 17.07.1998
(51) Int. Cl.: H03K 7/08

(54) **Procédé pour atténuer les effets des émissions électromagnétiques parasites produites par un signal de commande**
Verfahren zur Reduzierung der Wirkung der vom Steuersignal produzierten elektromagnetischen Störausstrahlungen
A method of reducing the effect of electromagnetic interference emissions produced by a control signal

(30) Priorité: 18.07.1997 FR 9709174
(43) Date de publication de la demande: 20.01.1999
(73) Titulaire: AUTOMOBILES PEUGEOT, 75116 Paris (FR); AUTOMOBILES CITROEN, 92200 Neuilly-sur-Seine (FR)
(72) Inventeur: Attia, Mondher, 92220 Bous-Colombes (FR); Allard, Damien, 49260 Vaudelnay (FR)
(74) Mandataire: Thinat, Michel

(56) Documents cités:
- EP-A- 0 373 357
- US-A- 5 394 022
- US-A- 5 589 805

## Description

La présente invention est relative à un procédé pour atténuer les effets des émissions électromagnétiques parasites produites par un signal de commande.

Dans de nombreux systèmes asservis, utilisant de façon générale un capteur de mesure d'une grandeur déterminée pour fournir un signal à un calculateur qui traite celui-ci avant d'adresser à un actionneur un ordre de commande en fonction de la grandeur ainsi mesurée, on peut utiliser divers modes de transmission.

Dans un premier de ces modes, on peut notamment transmettre, entre le calculateur et l'actionneur, un signal analogique qui est directement représentatif de la grandeur mesurée par le capteur. Toutefois, avec cette solution, la transmission de ce signal analogique, surtout sur une distance notable, est susceptible d'être perturbée, parfois de façon très sensible, par le bruit dû à la ligne de transmission et par les interférences avec l'environnement extérieur, d'où une précision médiocre dans la mise en oeuvre de l'actionneur qui présente nécessairement une certaine inertie, les faibles variations de la tension du signal ne pouvant pas être convenablement décelées vis-à-vis du bruit existant.

Un perfectionnement notable consiste à utiliser un signal numérique et notamment à commander l'actionneur en modulant la largeur des impulsions de ce signal, cette méthode étant généralement connue sous l'expression anglo-saxonne "Pulse Width Modulation", en abrégé PWM.

Dans ce cas, on dispose, au niveau de l'étage d'entrée de l'actionneur, un circuit intégrateur, la transmission du signal n'étant plus tributaire du bruit et des interférences. En revanche, elle produit une émission électromagnétique, transportée par la porteuse du signal modulé et les harmoniques de celui-ci.

Le brevet US-A-5 589 805 décrit un procédé pour créer un signal PWM (c'est-à-dire un signal à modulation de la largeur des impulsions). Or, il ne s'agit pas selon l'invention de créer un tel signal, mais de faire varier un de ses paramètres déjà existant et élaboré par ailleurs.

La présente invention a pour objet un procédé qui vise à atténuer ces inconvénients, en réduisant l'effet sur l'actionneur et l'environnement des émissions électromagnétiques créées par le signal PWM.

A cet effet, le procédé considéré se caractérise en ce qu'il consiste à réaliser, dans un signal numérique de type PWM, un étalement du spectre de ce signal par modulation

Un perfectionnement notable consiste à utiliser un signal numérique et notamment à commander l'actionneur en modulant la largeur des impulsions de ce signal, cette méthode étant généralement connue sous l'expression anglo-saxonne "Pulse Width Modulation", en abrégé PWM.

Dans ce cas, on dispose, au niveau de l'étage d'entrée de l'actionneur, un circuit intégrateur, la transmission du signal n'étant plus tributaire du bruit et des interférences. En revanche, elle produit une émission électromagnétique, transportée par la porteuse du signal modulé et les harmoniques de celui-ci.

Le brevet US-A-5 589 805 décrit un procédé pour créer un signal PWM (c'est-à-dire un signal à modulation de la largeur des impulsions). Or, il ne s'agit pas selon l'invention de créer un tel signal, mais de faire varier un de ses paramètres déjà existant et élaboré par ailleurs.

La présente invention a pour objet un procédé qui vise à atténuer ces inconvénients, en réduisant l'effet sur l'actionneur et l'environnement des émissions électromagnétiques créées par le signal PWM.

A cet effet, le procédé considéré se caractérise en ce qu'il consiste à réaliser, dans un signal numérique de type PWM, un étalement du spectre de ce signal par modulation aléatoire d'un de ses paramètres, provoquant une atténuation de l'amplitude de la porteuse et des amplitudes des harmoniques de ce signal.

Dans un tel signal numérique, on désigne par les termes "rapport cyclique du signal" le rapport entre la largeur de l'impulsion à l'intérieur d'une période et la durée de cette période.

Selon le cas et en référence aux deux modes de mise en oeuvre du procédé selon l'invention, le paramètre du signal auquel est appliqué la modulation aléatoire est soit la fréquence, soit la phase de ce signal, soit la combinaison des deux.

Dans le cas où la modulation aléatoire est celle de la fréquence du signal, le procédé consiste à faire choix d'un nombre déterminé de fréquences distinctes dans un intervalle de variation donné, de part et d'autre de la fréquence moyenne du signal, laquelle peut être quelconque et adaptée à la nature du capteur et de l'actionneur.

On notera dans ce cas que, si l'on fait varier la fréquence, donc la durée, d'une période déterminée, le rapport cyclique de cette période doit être conservé.

On constate dans ces conditions un étalement des fréquences, entraînant une diminution de l'amplitude du signal, l'atténuation de la porteuse et des harmoniques pouvant notamment atteindre 15 à 20 dB.

Dans le cas où la modulation concerne la phase du signal, la fréquence, donc la période de celui-ci restant constante, on introduit dans celle-ci un retard variable mais aléatoire pour l'impulsion de commande, tout en conservant le même rapport cyclique.

Avec cette solution, on constate derechef un étalement du spectre du signal, mais uniquement pour des valeurs faibles du rapport cyclique, notamment inférieur ou égal à 0,5. Au-delà, l'atténuation est faible voire inexistante si le rapport cyclique dépasse 0,5.

Pour pallier cet inconvénient et selon une autre caractéristique de l'invention, on décale l'état bas du signal de telle sorte que l'étalement de son spectre, dû à la modulation de phase de celui-ci, se produise cette fois uniquement pour les valeurs élevées du rapport cyclique.

Le procédé consiste avantageusement à combiner les deux effets précités, de la modulation de fréquence et de la modulation de phase, en fonction de la valeur du rapport cyclique, le spectre étant étalé par modulation de phase pour les valeurs respectivement basse et haute de ce rapport, et par modulation de fréquence pour les valeurs moyennes de celui-ci.

D'autres caractéristiques d'un procédé d'atténuation des effets des émissions électromagnétiques parasites d'un signal de commande, conforme à l'invention, apparaîtront encore à travers la description qui suit de plusieurs exemples de mise en oeuvre, donnés à titre indicatif et non limitatif, en référence aux dessins annexés sur lesquels :
- La Figure 1 est un schéma très simplifié d'un système de commande d'un actionneur à partir d'un calculateur au moyen d'un signal analogique, également illustré sur cette figure.
- La Figure 2 reprend le même schéma que sur la Figure 1, avec cette fois un signal numérique dans lequel est réalisée une modulation de la largeur des impulsions fournies pour la commande de l'actionneur.
- La Figure 3 illustre le spectre de fréquence du signal selon la Figure 2.
- La Figure 4 illustre le spectre de fréquence du même signal, après que celui-ci ait subi une modulation de fréquence aléatoire, montrant l'atténuation obtenue.
- La Figure 5 illustre le signal numérique de la Figure 2, sur lequel est réalisée une modulation de phase.
- La Figure 6 représente le signal numérique de la Figure 5, dans lequel on introduit un retard aléatoire variable, selon un autre mode de mise en oeuvre de l'invention.
- La Figure 7 illustre une autre variante de mise en oeuvre, avec modulation de phase du signal et décalage du niveau bas de celui-ci.
- La Figure 8 illustre le spectre de fréquence du signal en fonction de la valeur du rapport cyclique, tel qu'il peut être obtenu en réalisant une combinaison de la modulation de fréquence et de la modulation de phase du signal.

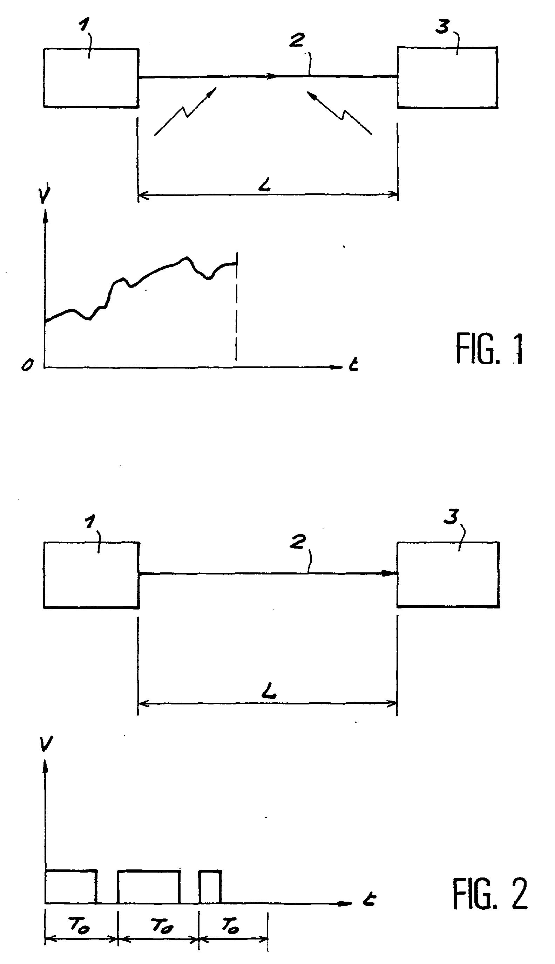

Sur la Figure 1, la référence 1 désigne schématiquement un calculateur, relié à un capteur de mesure (non représenté) d'une grandeur appropriée, la sortie de ce capteur étant traitée dans le calculateur pour produire un signal analogique de commande, transmis par une ligne 2 à un actionneur 3, comportant un intégrateur.

Sur cette même figure, on a également illustré le signal analogique ainsi transmis sur un graphique où V représente la tension.

On constate avec un système conçu de cette manière, surtout si la longueur L de la ligne de transmission 2 est importante, que le signal transmis est particulièrement sensible aux bruits environnants et aux interférences éventuelles avec d'autres signaux électromagnétiques transitant au voisinage.

Il en résulte une diminution parfois très sensible de la précision avec laquelle l'actionneur peut être commandé, surtout si la tension du signal de commande est faible, auquel cas ce signal ne se distingue pas aisément du bruit électronique ambiant.

La Figure 2 illustre tout aussi schématiquement un système analogue dans lequel néanmoins le calculateur et l'actionneur sont conçus de manière à pouvoir traiter et utiliser un signal numérique, les impulsions de commande de l'actionneur étant modulées en largeur, le signal étant dès lors défini sous le terme classique de "signal PWM", pour "Pulse Width Modulation".

Dans ce cas et comme on le voit également sur la Figure 2, la largeur des impulsions dans la période TO du signal est variable d'une impulsion à l'autre, la tension V de chaque impulsion étant constante.

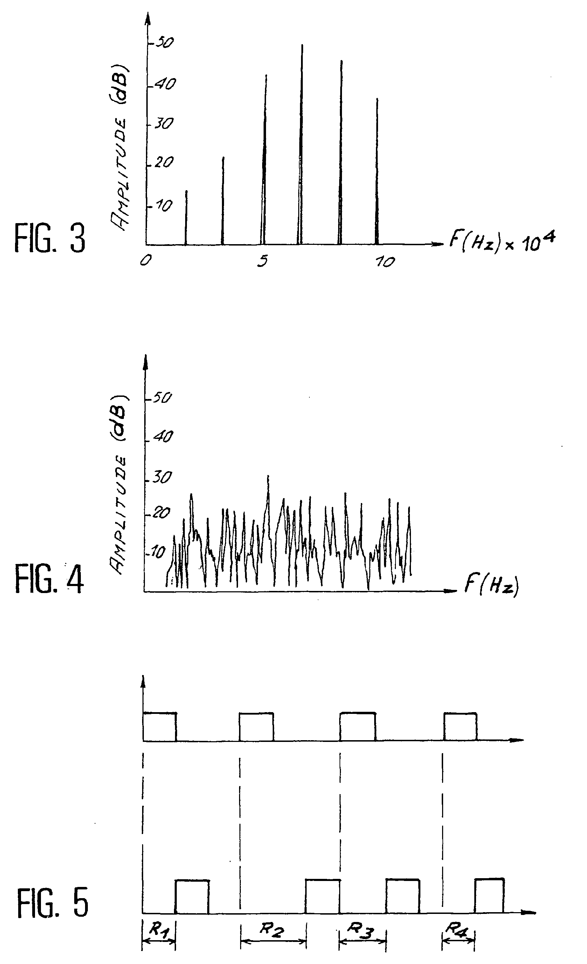

Avec un tel système, la transmission du signal n'est plus sujette aux bruits et aux interférences. Toutefois, elle entraîne une émission électromagnétique, avec la porteuse et les harmoniques du signal PWM, comme le schématise la Figure 3 qui représente le diagramme du signal avec l'amplitude exprimée en décibels en ordonnée et la fréquence en abscisse.

On constate que dans ce cas l'amplitude du signal est importante, l'invention consistant dès lors à effectuer un traitement de ce signal de manière à atténuer la porteuse et les harmoniques du spectre de ce signal, en réalisant un étalement de son spectre, afin de répartir ce signal dans une bande plus large autour de sa porteuse.

Selon l'invention, on réalise à cet effet une modulation, soit de la fréquence, soit de la phase du signal, pourvu que cette modulation soit aléatoire à l'intérieur de chaque période.

Dans le premier cas, on se fixe un intervalle de variation déterminé de la fréquence du signal autour de sa fréquence moyenne et un nombre de fréquences différentes dans cet intervalle, de part et d'autre de cette fréquence moyenne.

On traite alors le signal de façon aléatoire, de manière à ce que, pour chaque nouvelle impulsion, la fréquence choisie soit une quelconque des diverses fréquences offertes, la sélection de la fréquence pour chaque nouvelle période étant quelconque, à condition toutefois de conserver le rapport cyclique, ce dernier étant défini comme le rapport entre la largeur de l'impulsion à l'intérieur d'une période et la durée de cette période.

Comme schématisé sur la Figure 4, on constate que l'amplitude du signal fourni est alors sensiblement limitée par rapport à celle qui est représentée sur la Figure 3, l'atténuation moyenne de la porteuse pouvant atteindre 15 à 20 dB selon le rapport cyclique du signal.

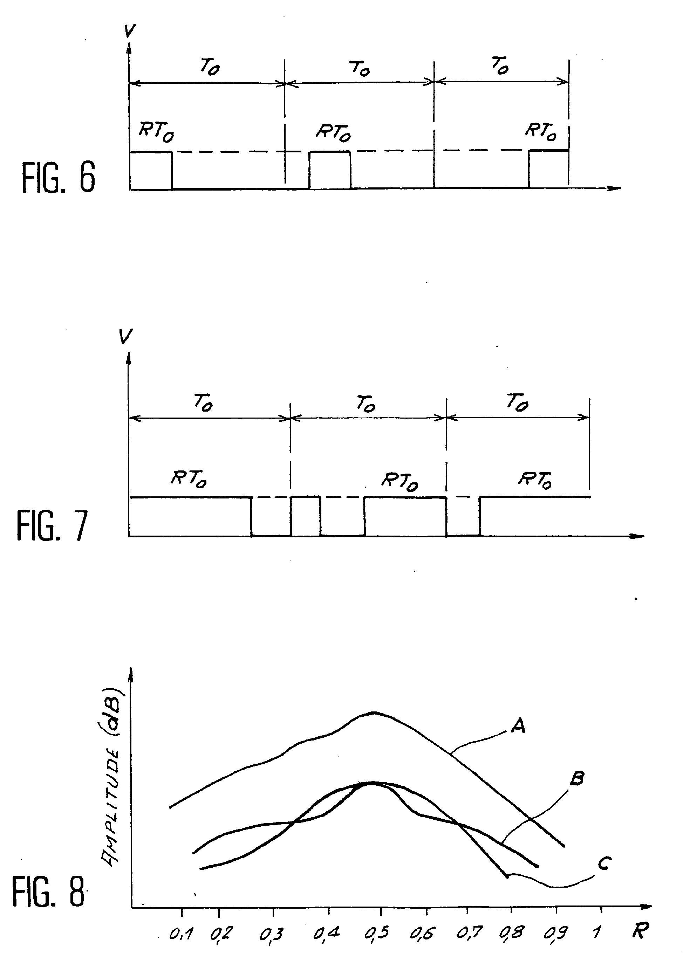

Dans la variante représentée sur les Figures 5 et 6, on procède cette fois à une modulation de la phase du signal, de manière à introduire dans celui-ci un retard R1, R2, R3, R4... variable et aléatoire de l'impulsion au cours de chaque période T0 (Figure 5), la valeur maximale de ce retard dépendant du rapport cyclique R et de la période du signal, comme schématisé sur la Figure 6.

On constate toutefois, avec cette seconde variante, que la modulation de phase du signal entraîne un étalement de son spectre notable, mais seulement pour des valeurs du rapport cyclique R de ce signal inférieures ou égales à 0,5. L'atténuation est pratiquement inexistante pour des valeurs supérieures.

Compte tenu de cette constatation, un perfectionnement du procédé selon l'invention consiste à décaler le niveau bas du signal, comme illustré sur la Figure 7, l'atténuation de ce signal étant cette fois constatée pour des valeurs du rapport cyclique R supérieures ou égales à 0,5.

La Figure 8 illustre l'évolution de l'amplitude du fondamental du signal en fonction du rapport cyclique et du type de modulation appliqué, avec un graphique où l'amplitude est portée en ordonnée et le rapport cyclique R en abscisse.

Sur ce graphique, la courbe A illustre le profil obtenu avec un signal PWM classique, tandis que les courbes B et C représentent le même signal modulé respectivement en fréquence et en phase.

On constate que pour des valeurs du rapport cyclique comprises entre 0,4 et 0,6, il est ainsi préférable d'appliquer une modulation de fréquence, alors que pour les valeurs inférieures et supérieures à ces limites, la modulation de phase produit un étalement satisfaisant, avec décalage du niveau bas du signal si le rapport cyclique est supérieur à 0,5.

Le traitement du signal selon ces diverses modalités peut être réalisé automatiquement à l'aide d'un circuit intégré approprié, l'atténuation obtenue étant particulièrement sensible et efficace.

Bien entendu, il va de soi que l'invention ne se limite pas aux exemples de mise en oeuvre du procédé plus spécialement décrits ci-dessus en référence aux dessins annexés ; elle en embrasse au contraire toutes les variantes.

## Revendications

1. Procédé pour atténuer les effets des émissions électromagnétiques parasites d'un signal de commande d'un actionneur (3), dans lequel on réalise, dans un signal numérique de type PWM (Pulse Width Modulation), un étalement du spectre de ce signal par modulation aléatoire d'un de ses paramètres, provoquant une atténuation de l'amplitude de la porteuse et des amplitudes des harmoniques de ce signal, et on réalise la modulation aléatoire sur la fréquence du signal, **caractérisé en ce qu'**il consiste à faire choix d'un nombre déterminé de fréquences distinctes dans un intervalle de variation donné, de part et d'autre de la fréquence moyenne du signal.

2. Procédé selon la revendication 1, **caractérisé en ce qu'**il consiste à combiner les effets de la modulation de fréquence et de la modulation de phase, en fonction de la valeur du rapport cyclique.

## Claims

1. A method for attenuating the effects of parasitic electromagnetic emissions of a signal for controlling an actuator (3), wherein, in a digital signal of the pulse width modulation (PWM) type, spreading-out of the spectrum of this signal is achieved by random modulation of one of its parameters, causing attenuation of the amplitude of the carrier and of the amplitudes of the harmonics of this signal, and random modulation is achieved on the frequency of the signal, **characterized in that** it consists of selecting a determined number of distinct frequencies in a given range of variation, on either side of the mean frequency of the signal.

2. The method according to claim 1, **characterized in that** it consists of combining the effect of frequency modulation and phase modulation, according to the duty cycle ratio.

## Patentansprüche

1. Verfahren zur Reduzierung der Wirkungen der vom Steuersignal eines Schalters (3) produzierten elektromagnetischen Störausstrahlungen, in dem in einem digitalen Signal vom Typ PWM (Pulsweitenmodulation) eine Spreizung des Spektrums dieses Signals durch aleatorische Modulation eines seiner Parameter durchgeführt wird, wodurch eine Reduzierung der Amplitude der Trägerwelle und der Amplituden der Oberwellen dieses Signals erfolgt, und die aleatorische Modulation über der Frequenz des Signals durchgeführt wird, **dadurch gekennzeichnet, dass** es darin besteht, eine bestimmte Anzahl verschiedener Frequenzen in einem gegebenen Variationsintervall zu beiden Seiten der mittleren Frequenz des Signals auszuwählen.

2. Verfahren nach Anspruch 1, **dadurch gekennzeichnet, dass** es darin besteht, die Wirkungen der Frequenzmodulation und der Phasenmodulation in Abhängigkeit des Wertes des Tastverhältnisses zu kombinieren.
